# EUROPEAN PATENT APPLICATION

(11) **EP 2 753 154 A1**
(43) Date of publication of application: **09.07.2014**
(21) Application number: 11871785.9
(22) Date of filing: 30.08.2011
(51) Int. Cl.: H05H 1/46, C23C 16/44, C23C 16/509, H01L 21/205, H01L 21/3065

(54) **ANTENNA FOR PLASMA PROCESSING APPARATUS, AND PLASMA PROCESSING APPARATUS USING ANTENNA**

(71) Applicant: EMD Corporation, Shiga 520-2323 (JP)
(72) Inventor: SETSUHARA, Yuichi, Suita-shi, Osaka 565-0871 (JP); EBE, Akinori, Yasu-shi, Shiga, 5202323 (JP)
(74) Representative: Hehl, Ulrich
(86) International application number: PCT/JP2011/069621
(87) International publication number: WO 2013/030953

(57) **Abstract**

Provided is a radio-frequency antenna with which the blocking or weakening of a radio-frequency induction electric field will not occur even if a thin-film material deposits on the antenna surface. A radio-frequency antenna 10 includes a linear antenna conductor 13, a dielectric protective pipe 14 provided around the antenna conductor 13, and a deposit shield 15 provided around the protective pipe 14, the deposit shield 15 covering at least one portion of the protective pipe 14 and having at least one opening 153 on any line extending along the length of the antenna conductor 13. Although the thin-film material adheres to the surfaces of the protective pipe and the deposit shield, the deposited substance has at least one discontinuous portion in the longitudinal direction of the antenna conductor. Therefore, in the case where the thin-film material is electrically conductive, the blocking of the radio-frequency induction electric field is prevented. In the case where the thin-film material is not electrically conductive, an attenuation in the intensity of the radio-frequency induction electric field is suppressed.

## Description

### TECHNICAL FIELD

The present invention relates to a radio-frequency antenna used in a plasma processing device, such as a chemical vapor deposition (CVD) device, sputtering device or etching device using plasma. The present invention also provides a plasma processing device using the radio-frequency antenna.

### BACKGROUND ART

In recent years, an internal antenna type plasma processing device having a radio-frequency antenna provided in a vacuum container has been developed and practically used. In this plasma processing device, a plasma generation gas is introduced into the vacuum container, and a radio-frequency electric current is passed through the radio-frequency antenna to generate a radio-frequency induction electric field around the antenna. The generated electric field accelerates electrons and ionizes gas molecules, thus generating plasma. By using this plasma, a target made of a raw material is sputtered or a material gas is decomposed, and thereby produced particles are supplied to a surface of a base body (substrate) to form a thin film or perform etching.

Patent Document 1 discloses a plasma processing device in which a plurality of radio-frequency antennas, each of which consists of a U-shaped conductor, are arranged in a vacuum container. The use of a plurality of radio-frequency antennas in this device aims at improving the uniformity of the plasma density in the vacuum container. A U-shaped radio-frequency plasma corresponds to an inductively coupled antenna whose number of turns is less than one, and its inductance is lower than that of an inductively coupled antenna whose number of turns is equal to or larger than one. The low inductance leads to a low radio-frequency voltage occurring at both ends of the radio-frequency antenna and a suppressed radio-frequency oscillation of the plasma potential caused by electrostatic coupling to the generated plasma. As a result, an excessive loss of electrons associated with the oscillation of the plasma potential relative to the ground potential is reduced, and the plasma potential is lowered. This condition enables a thin-film formation process to occur with a low degree of ion damage on the substrate.

If the radio-frequency antenna comes in direct contact with the plasma, an excessive amount of electrons flows from the plasma into the antenna due to the radio-frequency voltage occurring in the antenna, causing the potential of the plasma to be higher than that of the antenna. In this situation, the material used in the antenna may possibly be sputtered by the plasma, with the result that the material of the radio-frequency antenna is mixed in the thin film as an impurity. Therefore, in the device disclosed in Patent Document 1, the radio-frequency antennas are covered with a protective pipe made of an insulating material (dielectric material) so as to avoid direct contact with the plasma.

### BACKGROUND ART DOCUMENT

### PATENT DOCUMENT

Patent Document 1: JP-A 2001-035697 (Paragraphs [0050], [0052] and [0053] as well as Figs. 1 and 11)

### SUMMARY OF THE INVENTION

### PROBLEM TO BE SOLVED BY THE INVENTION

If the plasma processing device of Patent Document 1 is continuously used for a thin-film formation or etching process, the material of the thin film, or the dissociated species of gas molecules used in the etching process or its byproduct will gradually deposit on the surface of the protective pipe, and eventually, the pipe surface will be entirely covered with a layer of the deposited substance. If this state is reached, and if the deposited substance is electrically conductive, a passage of the radio-frequency electric current through the radio-frequency antennas causes a countercurrent of electricity in the deposited layer, whereby the radio-frequency induction electric field is blocked. Even if the deposited substance is not electrically conductive, the radio-frequency induction electric field undergoes an attenuation of its intensity when it passes through the deposited layer.

The problem to be solved by the present invention is to provide a radio-frequency antenna with which the blocking of the radio-frequency induction electric field or the attenuation of its intensity will not occur even if a substance is deposited on the surface of an antenna-protecting pipe. Also provided is a plasma processing device using this radio-frequency antenna.

### MEANS FOR SOLVING THE PROBLEM

A radio-frequency antenna according to the present invention aiming at solving the previously described problem is a radio-frequency antenna to be provided in a vacuum container, for passing a radio-frequency electric current so as to generate a radio-frequency induction electric field in the vacuum container and thereby turn a plasma generation gas introduced in the vacuum container into plasma, including:
a) a linear antenna conductor;
b) a dielectric protective pipe provided around the antenna conductor; and
c) a deposit shield provided around the protective pipe, the deposit shield covering at least one portion of the protective pipe and having at least one opening on any line extending along the length of the antenna conductor.

In the radio-frequency antenna according to the present invention, the deposited substance does not continuously adhere to the surface of the protective pipe in the longitudinal direction of the pipe during the thin-film formation or etching process, nor does it continuously adhere to the surface of the shield in the longitudinal direction. Therefore, in the case where the deposited substance is electrically conductive, no countercurrent of electricity is generated in the deposited layer when a radio-frequency electric current is passed through the antenna conductor, and hence no blocking of the radio-frequency induction electric field occurs. In the case where the deposited substance is not electrically conductive, the blocking of the radio-frequency induction electric field by a continuous layer of the deposited substance does not occur, so that a decrease in the plasma generation capability is suppressed.

For example, the deposit shield may have a discontinuous portion in the longitudinal direction of the protective pipe. In this case, the discontinuous portion of the shield corresponds to the aforementioned opening. Another example is a belt-shaped member spirally extending along the length of the protective pipe with a blank area between one turn of the belt and another. In this case, the blank area between the neighboring turns of the belt corresponds to the aforementioned opening. Still another example is a pipe-shaped member having an array of circumferentially elongated holes arranged circumferentially, where such arrays are arranged along the length of the pipe and each array is displaced circumferentially from one another.

Between the deposit shield and the protective pipe, a dividing portion protruding from the protective pipe may preferably be provided, the dividing portion circumferentially surrounding the protective pipe or spirally extending along the length of the protective pipe. The dividing portion assuredly prevents the material of the thin film from depositing continuously in the longitudinal direction on the surface of the protective pipe.

A first mode of the plasma processing device according the present invention includes:
a) a vacuum container;
b) a target holder provided in the vacuum container;
c) a substrate holder facing the target holder;
d) a plasma generation gas introducing section for introducing a plasma generation gas into the vacuum container;
e) an electric field generator for generating a sputtering direct-current electric field or radio-frequency electric field in a region including a surface of a target to be held by the target holder; and
f) a radio-frequency antenna according to the present invention, provided in the vacuum container, for generating a radio-frequency induction electric field in the region including the surface of the target held by the target holder.

The first mode of the plasma processing device corresponds to a device obtained by providing a conventional sputtering device with a radio-frequency antenna according to the present invention so as to generate a radio-frequency induction electric field in a region near the surface of the target.

In a conventional sputtering device, molecules of a plasma generation gas are ionized by an electric field generator to generate plasma, and the generated ions are made to collide with a target to sputter this target. The material sputtered from the target is made to deposit on a substrate, forming a thin film. By contrast, in the first mode of the plasma processing device, the radio-frequency induction electric field generated by the radio-frequency antenna provided in the vacuum container further increases the plasma density in a region near the surface of the target, so that the target can be sputtered at higher rates. However, in this device, since the radio-frequency antenna is provided within the vacuum container, the thin-film material resulting from the sputtering of the target adheres to the surface of the radio-frequency antenna. This being taken into account, a radio-frequency antenna according to the present invention is used in the first mode of the plasma processing device so as to prevent a decrease in the intensity of the radio-frequency induction electric field.

The first mode of the plasma processing device (sputtering device) may preferably include a magnetic field generator for generating a magnetic field having a component orthogonal to the direct-current electric field or the radio-frequency electric field in the region including the surface of the target. This configuration corresponds to a device obtained by providing a conventional magnetron sputtering device with a radio-frequency antenna according to the present invention.

A second mode of the plasma processing device according to the present invention includes:
a) a vacuum container;
b) a substrate holder provided in the vacuum container;
c) a plurality of radio-frequency antennas according to the present invention provided in the vacuum container;
d) a plasma generation gas introducing section for introducing a plasma generation gas into the vacuum container; and
e) a material gas introducing section for introducing a gas serving as a material of a thin film into the vacuum container. This plasma processing device corresponds to a device obtained by using a plurality of radio-frequency antennas according to the present invention as the radio-frequency antennas in the plasma processing device disclosed in Patent Document 1.

A third mode of the plasma processing device according to the present invention includes:
a) a vacuum container;
b) an object holder provided in the vacuum container;
c) a plurality of radio-frequency antennas according to the present invention provided in the vacuum container;
d) a plasma generation gas introducing section for introducing a plasma generation gas into the vacuum container; and
e) an etching process gas introducing section for introducing, into the vacuum container, a gas to be used in an etching process.

### EFFECT OF THE INVENTION

In the radio-frequency antenna according to the present invention, the deposited layer formed on the surfaces of the protective pipe and the deposit shield due to the deposition of a material of a thin film or a material gas to be used for etching has at least one discontinuous portion on any line extending along the length of the antenna conductor. Therefore, the blocking of the radio-frequency induction electric field is prevented in the case where the deposited substance is electrically conductive, or an attenuation of the intensity of the radio-frequency induction electric field is suppressed in the case of an electrically non-conductive substance.

### BRIEF DESCRIPTION OF THE DRAWINGS

Fig. 1A is a vertical sectional view showing a first embodiment of the radio-frequency antenna according to the present invention, and Fig. 1B is a side view showing a portion of the same radio-frequency antenna.
Fig. 2 is a diagram for explaining the function of the deposit shield in the radio-frequency of the first embodiment.
Fig. 3 is a vertical sectional view showing a sputtering device as one embodiment of the plasma processing device in which a radio-frequency antenna according to the present invention is used.
Figs. 4A and 4B are a vertical view (Fig. 4A) and a plan view (Fig. 4B) showing a plasma CVD device or plasma etching device as one embodiment of the plasma processing device in which a radio-frequency antenna according to the present invention is used.
Fig. 5 is a vertical sectional view of a radio-frequency antenna of a second embodiment.
Fig. 6 is a diagram for explaining the function of the deposit shield in the radio-frequency antenna of the second embodiment.
Fig. 7 is a vertical sectional view of a radio-frequency antenna of a third embodiment.
Fig. 8 is a diagram for explaining the function of the deposit shield in the radio-frequency antenna of the third embodiment.
Fig. 9 is a front view of a portion of a fin and a dielectric pipe in a variation of the third embodiment.
Fig. 10A is a sectional view of a radio-frequency antenna of a fourth embodiment at a plane perpendicular to the linear conductor, and Figs. 10B and 10C are developed views of the same antenna.
Fig. 11 is a longitudinal sectional view for explaining the function of the deposit shield in the radio-frequency antenna of the fourth embodiment.

### MODE FOR CARRYING OUT THE INVENTION

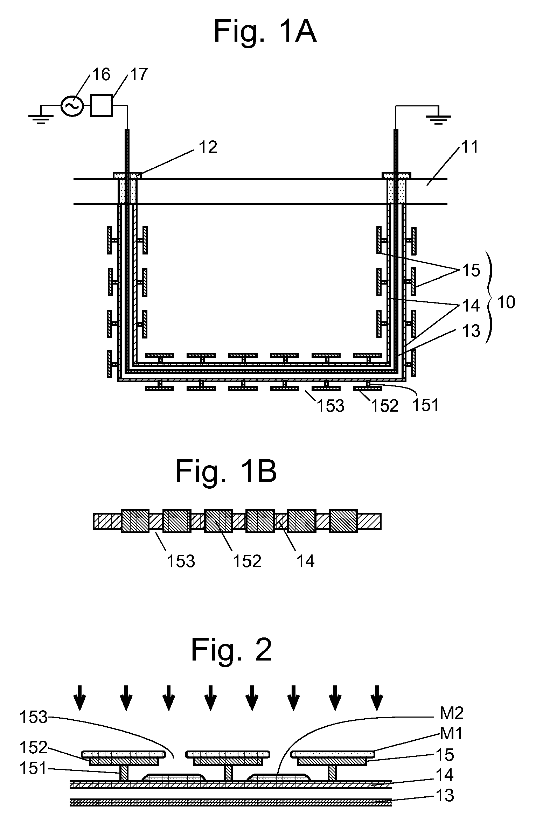

Embodiments of the radio-frequency antenna for a plasma processing device according to the present invention, as well as those of the plasma processing device using the radio-frequency antenna, are hereinafter described by means of Figs. 1-11.

### FIRST EMBODIMENT

The first embodiment of the radio-frequency antenna according to the present invention is hereinafter described by means of Figs. 1A-4B. The present radio-frequency antenna 10 has an antenna conductor 13 consisting of a U-shaped linear conductor, a dielectric pipe 14 that has a circular cross section and that is bent in a U-shape in such a manner as to cover the antenna conductor 13, as well as a deposit shield 15 provided on the outer surface of the dielectric pipe 14. Details of the deposit shield 15 will be described later. It should be noted that Fig 1A is a sectional view at a plane parallel to the antenna conductor 13. The radio-frequency antenna 10 is attached to a wall surface of a vacuum container 11 of a plasma processing device via feedthroughs 12. A radio-frequency power source 16 is connected to the antenna conductor 13 via an impedance matching box 17. The U-shaped radio-frequency antenna 13 corresponds to an inductively coupled antenna whose number of turns is less than one, and hence has an inductance lower than that of an inductively coupled antenna whose number of turns is equal to or larger than one. The low inductance leads to a decrease in the radio-frequency voltage occurring at both ends of the radio-frequency antenna and a suppression of the radio-frequency oscillation of the plasma potential due to electrostatic coupling to the generated plasma. As a result, an excessive loss of the electrons due to the oscillation of the plasma potential relative to the ground potential is reduced, and the plasma potential is lowered. This condition enables a thin-film formation process with a low degree of ion damage on the substrate.

The deposit shield 15 has a leg portion (dividing portion) 151 extending outward from the outer surface of the dielectric pipe 14 and an eave portion 152 extending from the upper end of the leg portion 151 toward both sides along the length of the dielectric pipe 14. Accordingly, the leg portion 151 and the eave portion 152 as combined together have a T-shaped appearance in the vertical sectional view in Fig. 1A. Both the leg portion 151 and the eave portion 152 are formed so as to circumferentially surround the dielectric pipe 14. A number of leg portions 151 and eave portions 152 are arranged along the length of the dielectric pipe 14, with a gap between the neighboring eave portions 152. That is to say, the elements constituting the deposit shield 15 are separated from each other at the gap between the eave portions. This separated portion is hereinafter called the opening 153. The deposit shield 15 can be made of either electrically conductive materials or dielectric materials.

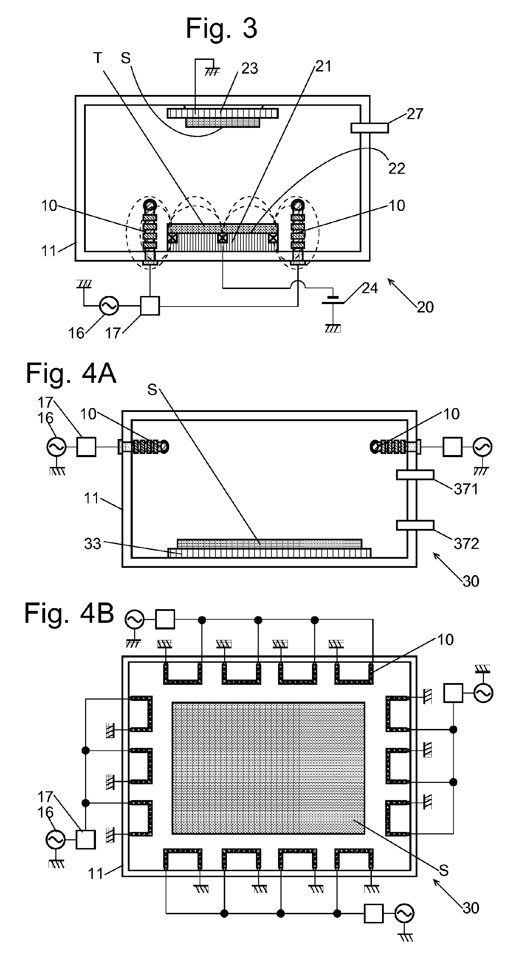

The radio-frequency antenna 10 of the present embodiment is used in a plasma processing device as shown in Fig. 3 or Figs. 4A and 4B (e.g. a sputtering device, plasma CVD device or plasma etching device) or in similar devices. Details of those plasma processing devices will be described later. These are devices for forming a thin film on a substrate by a process in which, with a cloud of plasma generated by a radio-frequency induction electric field produced by the radio-frequency antenna 10, a target made of a raw material for a thin film is sputtered by the ions in the plasma, or a material gas for a thin film is decomposed. In the process, the raw material of the thin film or the etching process gas adheres to the surface of the radio-frequency antenna 10. Accordingly, whether or not the deposited substance adversely affects the properties of the radio-frequency antenna 10 becomes a problem. A particularly critical problem is the blocking of the radio-frequency induction electric field, which can occur if an electrically conductive substance continuously deposits along the length of the linear conductor, allowing an electric current to pass through the adhering substance in such a manner as to cancel the temporally changing electric field which is generated around the antenna conductor 13 when a radio-frequency electric current is passed through the antenna conductor 13.

In the present embodiment, since the deposit shield 15 is present, the deposited substance can barely have adverse effects on the properties of the radio-frequency antenna 10. The reason is as follows: As shown in Fig. 2, a portion of the material particles flying toward the radio-frequency antenna 10 (as indicated by the arrows in Fig. 2) deposits on the outside of the eave portions 152 (outer deposits M1), while the other portion passes through the openings 153 and deposits on the outer surface of the dielectric pipe 14 (inner deposits M2). The openings 153 formed between the neighboring eave portions 152 prevent the outer deposits M1 adhering to the eave portions 152 from being interconnected. The outer deposits M1 will not be interconnected at least until a considerable period of time elapses from the first operation of the plasma processing device.

Additionally, nor will the inner deposits M2 be interconnected in the longitudinal direction of the dielectric pile 14 (regardless of the use time of the device) since the outer surface of the pipe is divided into separate sections along the longitudinal direction by the leg portions (dividing portions) 151.

Thus, the deposit shield 15 prevents the outer and inner deposits M1 and M2 from being continuously interconnected in the longitudinal direction of the dielectric pipe 14 (at least for a considerable period of time). Therefore, particularly in the case where the deposited substance is electrically conductive, the blocking of the radio-frequency induction electric field does not occur. In the case where the deposited substance is not electrically conductive, the decrease in the intensity of the radio-frequency induction electric field will be suppressed (at least for a considerable period of time). Furthermore, the operating cost of the device will be reduced since the maintenance task of regularly removing the deposited substance is unnecessary or the cycle of such a task can be longer.

If the distance between the tip of the eave portion 152 and the leg portion 151 is larger than a certain length, the thin-film material passing through the opening 153 cannot reach beyond an intermediate position from the tip of the eave portion 152 toward the leg portion 151. In this situation, at least a portion of the outer surface of the dielectric pipe 14 is located in the "shadow" of the eave portion and hence is not covered with the inner deposit M2, so that the decrease in the intensity of the radio-frequency induction electric field will more assuredly be prevented. To obtain such an effect, the distance between the tip of the eave portion 152 and the leg portion 151 should preferably be no less than two times the size of the gap between the eave portion 152 and the dielectric pipe 14.

A plasma processing device (sputtering device) 20 using the radio-frequency antenna 10 of the present embodiment is hereinafter described. The plasma processing device 20 has a magnet 21 for magnetron sputtering provided at the bottom of the vacuum container 11, a target holder 22 provided on the upper surface of the magnet 21, and a substrate holder 23 facing the target holder 22, with the radio-frequency antenna 10 of the present embodiment provided laterally to the magnet 21 for magnetron sputtering. A plate-shaped target T can be attached to the upper surface of the target holder 22, while a substrate S can be attached to the lower surface of the substrate holder 23. This plasma processing device 20 is provided with a direct-current power source 24 for applying a direct-current voltage between the target holder 22 and the substrate holder 23, with the target holder 22 on the positive side, as well as the previously mentioned radio-frequency power source 16 connected to the radio-frequency antenna 10 via the impedance matching box 17. Additionally, a gas inlet 27 for introducing a gas for generating plasma (plasma generation gas) into the vacuum container 11 is provided in the side wall of the vacuum container 11.

An operation of the plasma processing device 20 is hereinafter described. Initially, a target T and a substrate S are attached to the target holder 22 and the substrate holder 23, respectively. After the vacuum container 11 is evacuated, a plasma generation gas is introduced from the gas inlet 27 into the vacuum container 11. Subsequently, a direct current is passed through the electromagnet in the magnet 21 for magnetron sputtering to generate a magnetic field in the vicinity of the target T. Simultaneously, a direct-current electric field is generated between the target holder 22 and the substrate holder 23 by means of the direct-current power source 24, using the two holders as electrodes. Furthermore, a radio-frequency power is supplied from the radio-frequency power source 16 to the antenna conductor 13 to generate a radio-frequency induction electric field around the radio-frequency antenna 10 including the vicinity of the target T. Due to the magnetic field, the direct-current electric field and the radio-frequency induction electric field, plasma is generated. The electrons supplied from the plasma make a cycloid or trochoid motion under the effects of the magnetic field and the direct-current electric field, whereby the ionization of the plasma generation gas is promoted, producing a considerable amount of positive ions. Those positive ions bombard the surface of the target T, causing particles to be sputtered off the surface of the target T. The sputtered particles fly in the space between the target T and the substrate S and adhere to the surface of the substrate S. Thus, the sputtered particles deposit on the surface of the substrate S to form a thin film.

In this device, the sputtered particles adhere to the radio-frequency antenna 10. However, since the deposit shield 15 is present, the blocking or weakening of the radio-frequency induction electric field generated by the radio-frequency antenna 10 will not occur.

The description thus far utilized a magnetron sputtering device as an example. The radio-frequency antenna 10 of the present embodiment can similarly be provided laterally to the target holder 22 in a bipolar sputtering device which is obtained by removing the magnet 21 for magnetron sputtering from the plasma processing device 20.

Another plasma processing device 30 using the radio-frequency antenna 10 of the present embodiment is hereinafter described. The plasma processing device 30 includes a substrate holder 33 provided at the bottom of the vacuum container 11 and a plurality of radio-frequency antennas 10 arranged on the side wall of the vacuum container 11 parallel to the substrate S placed on the substrate holder 33. The plurality of radio-frequency antennas 10 are divided into groups, each group including three or four antennas parallel-connected to one radio-frequency power source 16. The vacuum container 11 has two gas inlets provided in its side wall, i.e. a first gas inlet 371 for introducing a plasma generation gas into the vacuum container 11 and a second gas inlet 372 for introducing a gas to be used as a material for a thin film (thin-film material gas) or an etching process gas into an area in the vacuum container 11 closer to the substrate holder 33 than the area into which the plasma generation gas is introduced.

An operation of the plasma processing device 30 is hereinafter described. Initially, after a substrate S is attached to the substrate holder 33, the vacuum container 11 is evacuated. Next, the plasma generation gas and the thin-film material gas are respectively introduced from the first and second gas inlets 371 and 372 into the vacuum container 11. A radio-frequency electric current is supplied from the radio-frequency power sources 16 to the antenna conductors 13, whereby a radio-frequency induction electric field is generated in the vacuum container 11. The radio-frequency induction electric field accelerates electrons, whereby the plasma generation gas is ionized and plasma is generated. Due to collisions with the electrons in the plasma, the thin-film material gas or etching process gas is decomposed, causing a thin-film formation or etching process on the substrate S. It should be noted that the object to be processed, which is the substrate S in the present example, does not need to be a plate-shaped object in the case of an etching process.

The adhesion of the decomposed thin-film material or the etching process gas to the radio-frequency antenna also occurs in the present plasma processing device 30. However, since the deposit shield 15 is present, the blocking or weakening of the radio-frequency induction electric field due to the adhering substance will not occur.

In the previously described plasma processing devices 20 and 30, a radio-frequency antenna according to any one of the second and subsequent embodiments (which will be described later) can be used in place of the radio-frequency antenna 10 of the first embodiment.

### SECOND EMBODIMENT

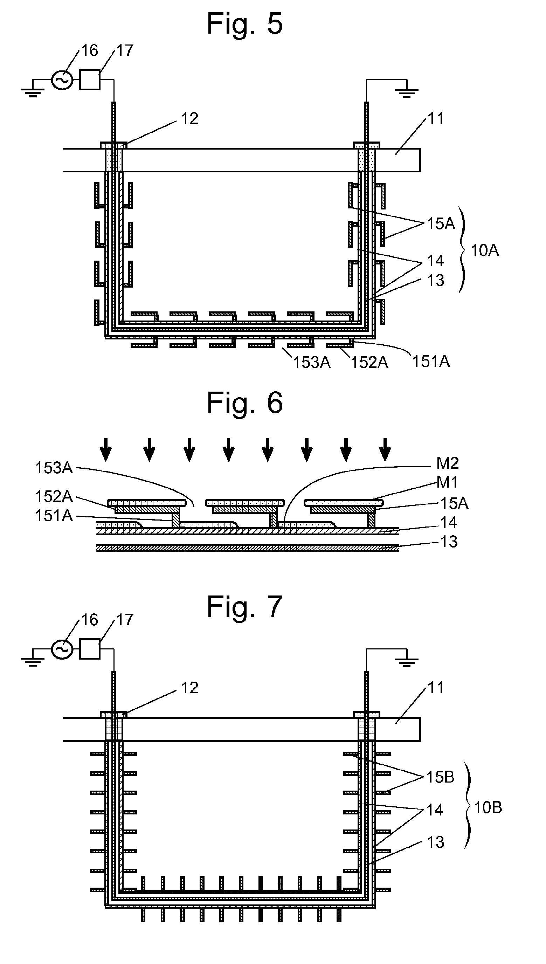

The second embodiment of the radio-frequency antenna according to the present invention is hereinafter described by means of Figs. 5 and 6. The radio-frequency antenna 10A of the present embodiment has an antenna conductor 13 and a dielectric pipe 14, which are the same as those used in the radio-frequency antenna 10 of the first embodiment, as well as a deposit shield 15A provided on the outer surface of the dielectric pipe 14 (Fig. 5). The deposit shield 15A has a leg portion 151A extending outward from the outer surface of the dielectric pipe 14 and an eave portion 152A extending from the upper end of the leg portion 151A toward one side along the length of the dielectric pipe 14. Accordingly, the leg portion 151 and the eave portion 152 as combined together have an L-shaped appearance in the vertical sectional view in Fig. 5A.

As shown in Fig. 6, the radio-frequency antenna 10A of the present embodiment has an opening 153A between the neighboring eave portions 152A, as in the radio-frequency antenna 10 of the first embodiment. Therefore, the outer deposits M1 adhering to the eave portions 152A cannot be interconnected (at least until a considerable period of time elapses from the first operation of the plasma processing device). Additionally, nor will the inner deposits M2 be interconnected in the longitudinal direction of the dielectric pile 14 since the outer surface of the pipe is divided into separate sections along the longitudinal direction by the leg portions (dividing portions) 151A. Furthermore, at least a portion of the outer surface of the dielectric pipe 14 is not covered with the inner deposit M2 since the thin-film material cannot reach beyond an intermediate position from the tip of the eave portion 152A toward the leg portion 151A. Due to such reasons, particularly in the case where the adhering substance is electrically conductive, the blocking of the radio-frequency induction electric field will not occur. In the case where the adhering substance is not electrically conductive, the decrease in the intensity of the radio-frequency induction electric field will be suppressed.

### THIRD EMBODIMENT

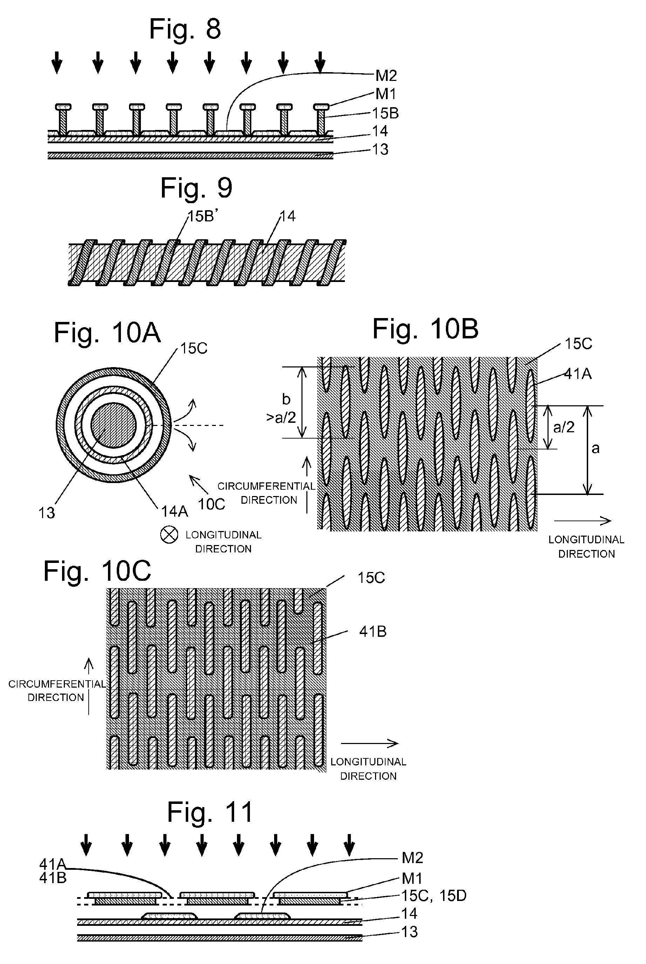

The third embodiment of the radio-frequency antenna according to the present invention is hereinafter described by means of Figs. 7 and 8. The radio-frequency antenna 10B of the present embodiment has an antenna conductor 13 and a dielectric pipe 14, which are the same as those used in the radio-frequency antennas of the first and second embodiments, as well as a deposit shield (fin 15B) provided on the outer surface of the dielectric pipe 14 (Fig. 7). Each fin 15B stands outward from the outer surface of the dielectric pipe 14 and circumferentially surrounds the dielectric pipe 14. A number of fins 15B are arranged at intervals adequately larger than their thickness along the length of the dielectric pipe 14.

In the radio-frequency antenna 10B of the present embodiment, as shown in Fig. 8, the width of the tip of the fin 15B as measured in the longitudinal direction of the antenna conductor 13 is adequately smaller than the intervals between the fins, so that the deposit M1 that is adhering to this tip can barely extend in that direction. Accordingly, the deposits M1 will not be interconnected in that direction. Additionally, nor will the deposits M2 be interconnected in the longitudinal direction, since the outer surface of the dielectric pipe 14 is divided into separate sections by the fins 15B. Thus, the blocking of the radio-frequency induction electric field will be prevented and the decrease in the intensity of the radio-frequency induction electric field will be suppressed, as in the cases of the first and second embodiments.

Although the thin-film material also adheres to the side surface of the fin 15B, the material can barely form a layer on that surface since the amount of adhering material per unit area on that surface is adequately smaller than at the tip of the fin 15B or on the outer surface of the dielectric pipe 14. Even if such a layer is formed, the electric current that causes the blocking of the electromagnetic field can only flow in small amount, since the layer is extremely thin, and furthermore, since the route of the electric current is longer than in the case where no fin 15B is present.

In the third embodiment, a similar effect can be obtained by using a single fin 15B' that spirally extends along the length of the dielectric pipe 14 (Fig. 9) in place of a number of fins individually and circumferentially formed around the dielectric pipe 14.

### FOURTH EMBODIMENT

The fourth embodiment of the radio-frequency antenna according to the present invention is hereinafter described by means of Figs. 10A-11. As shown in Fig. 10A, the radio-frequency antenna 10C of the present embodiment has an antenna conductor 13 and a dielectric pipe 14, which are the same as those of the radio-frequency antennas of the first through third embodiments, as well as a deposit shield 15C provided on the outside of the dielectric pipe 14. The deposit shield 15C consists of a dielectric pipe in which a large number of holes 41A or 42B are formed. The material of the pipe of the deposit shield 15C may be the same as or different from the dielectric pipe 14. A void space is formed between the dielectric pipe 14 and the deposit field 15C, and there is no element that corresponds to the leg portion in the first or second embodiment. The height of the void space (the distance between the outer surface of the dielectric pipe 14 and the inner surface of the deposit shield 15C) is constantly maintained by fixing both the dielectric pipe 14 and the deposit shield 15C to the feedthroughs 12.

Fig. 10B shows the shape and the position of the holes 41A, and Fig. 10C shows those of the holes 41B. Both of Figs. 10B and 10C show the deposited shield 15C as cut along the longitudinal direction and opened. The holes 41A have an elliptic shape elongated in the circumferential direction of the deposit shield 15C. A plurality of holes 41A are arranged in a column at regular intervals of a in that direction. A number of such columns are arranged along the length of the deposit shield 15C. The holes 41A constituting one columns are displaced from those constituting the neighboring column by a length of a/2 in the circumferential direction, and the major diameter b of the hole is larger than a/2. Such a design results in a hole 41A being present in the longitudinal direction from any position on the surface of the deposit shield 15C. The holes 41B are identical to the holes 41A except that the holes 41 B have a rectangular shape elongated in the circumferential direction of the deposit shield 15C.

The presence of the holes 41A or 41B in the longitudinal direction from any position on the surface of the deposit shield 15C means that, as shown in Fig. 11, the outer deposit M1 that adheres to the surface of the deposit shield 15C cannot be formed straight, at least in the longitudinal direction. Therefore, when a radio-frequency electric current is passed through the antenna conductor 13, the situation where an electric current flows in the longitudinal direction and blocks the radio-frequency induction electric field will be prevented. Furthermore, since the wall between the holes 41A or 41B in the deposit shield 15C has the same function as the eave portion in the first and second embodiments, the inner deposits M2 will not be interconnected in the section located in the "shadow" of the wall on the outer surface of the dielectric pipe 14, and the block of the radio-frequency induction electric field can be prevented. To obtain this effect, it is desirable that the portion covering the dielectric pipe 14 in the section between the holes of the neighboring columns have a width no less than two times the size of the gap between the dielectric pipe 14 and the deposit shield 15C.

### EXPLANATION OF NUMERALS

- 10, 10A, 10B, 10C: Radio-Frequency Antenna
- 11: Vacuum Container
- 12: Feedthrough
- 13: Antenna Conductor
- 14: Dielectric Pipe
- 15, 15A, 15C: Deposit Shield
- 151, 151A: Leg Portion
- 152, 152A: Eave Portion
- 153, 153A: Opening
- 15A: Deposit Shield
- 15B: Fin
- 16: Radio-Frequency Power Source
- 17: Impedance Matching Box
- 20: Plasma Processing Device (Sputtering Device)
- 21: Magnet for Magnetron Sputtering
- 22: Target Holder
- 23, 33: Substrate Holder
- 24: Direct-Current Power Source
- 27: Gas Inlet
- 30: Plasma Processing Device (Plasma CVD device or Plasma Etching Device)
- 371: First Gas Inlet
- 372: Second Gas Inlet
- 41A, 41B: Hole
- 5: Substrate
- T: Target

## Claims

1. A radio-frequency antenna to be provided in a vacuum container, for passing a radio-frequency electric current so as to generate a radio-frequency induction electric field in the vacuum container and thereby turn a plasma generation gas introduced in the vacuum container into plasma, comprising:
a) a linear antenna conductor;
b) a dielectric protective pipe provided around the antenna conductor; and
c) a deposit shield provided around the protective pipe, the deposit shield covering at least one portion of the protective pipe and having at least one opening on any line extending along a length of the antenna conductor.

2. The radio-frequency antenna according to claim 1, wherein the deposit shield has a discontinuous portion in a longitudinal direction of the protective pipe.

3. The radio-frequency antenna according to claim 1, wherein the deposit shield is a belt-shaped member spirally extending along a length of the protective pipe with a blank area between one turn of the belt and another.

4. The radio-frequency antenna according to claim 1, wherein the deposit shield is a pipe-shaped member having an array of circumferentially elongated holes arranged circumferentially, where such arrays are arranged along the length of the pipe and each array is displaced circumferentially from one another.

5. The radio-frequency antenna according to one of claims 1-4, wherein a dividing portion protruding from the protective pipe is provided between the deposit shield and the protective pipe, the dividing portion circumferentially surrounding the protective pipe.

6. The radio-frequency antenna according to one of claims 1 through 4, wherein a dividing portion protruding from the protective pipe is provided between the deposit shield and the protective pipe, the dividing portion spirally extending along a length of the protective pipe.

7. The radio-frequency antenna according to one of claims 1 through 6, wherein the antenna conductor is an inductively coupled antenna with a number of turns less than one.

8. The radio-frequency antenna according to claim 7, wherein the antenna conductor is U-shaped.

9. A plasma processing device, comprising:
a) a vacuum container;
b) a target holder provided in the vacuum container;
c) a substrate holder facing the target holder;
d) a plasma generation gas introducing section for introducing a plasma generation gas into the vacuum container;
e) an electric field generator for generating a sputtering direct-current electric field or radio-frequency electric field in a region including a surface of a target to be held by the target holder; and
f) a radio-frequency antenna according to one of claims 1 through 8, provided in the vacuum container, for generating a radio-frequency induction electric field in the region including the surface of the target held by the target holder.

10. The plasma processing device according to claim 9, further comprising a magnetic field generator for generating a magnetic field having a component orthogonal to the direct-current electric field or the radio-frequency electric field in the region including the surface of the target.

11. A plasma processing device, comprising:
a) a vacuum container;
b) a substrate holder provided in the vacuum container;
c) a plurality of radio-frequency antennas according to one of claims 1 through 8 provided in the vacuum container;
d) a plasma generation gas introducing section for introducing a plasma generation gas into the vacuum container; and
e) a material gas introducing section for introducing a gas serving as a material of a thin film into the vacuum container.

12. A plasma processing device, comprising:
a) a vacuum container;
b) an object holder provided in the vacuum container;
c) a plurality of radio-frequency antennas according to one of claims 1 through 8 provided in the vacuum container;
d) a plasma generation gas introducing section for introducing a plasma generation gas into the vacuum container; and
e) an etching process gas introducing section for introducing, into the vacuum container, a gas to be used in an etching process.
